# EUROPEAN PATENT SPECIFICATION

(11) **EP 0 471 507 B1**
(45) Date of publication and mention of the grant of the patent: **16.10.1996**
(21) Application number: 91307286.4
(22) Date of filing: 08.08.1991
(51) Int. Cl.: H01L 23/10, H01L 21/50

(54) **Plastic cavity package lid seal process**
Dichtungsverfahren für einen Deckel einer hohlen Plastikpackung
Procédé de scellage du couvercle d'un empaquetage creux en plastique

(30) Priority: 08.08.1990 US 564487
(43) Date of publication of application: 19.02.1992
(73) Proprietor: TEXAS INSTRUMENTS INCORPORATED, Dallas Texas 75265 (US)
(72) Inventor: Bohon, Bruce D., Garland, Texas 75040 (US)
(74) Representative: Blanco White, Henry Nicholas

(56) References cited:
- EP-A- 0 354 800
- US-A- 4 874 722
- PATENT ABSTRACTS OF JAPAN, vol. 14, no. 476 (E-0991) 17 October 1990 & JP-A-02 196 446
- PATENT ABSTRACTS OF JAPAN, vol. 14, no. 225 (E-0927) 14 May 1990 & JP-A-02 058 355
- GLOW DISCHARGE PROCESSES, B. CHAPMAN; J. WILEY & SONS, NEW YORK (US), 1980, pages 253, 255

## Description

### TECHNICAL FIELD OF THE INVENTION

This invention pertains in general to cavity packaging of semiconductor devices and more particularly to a process for obtaining a seal between the lid and body of a cavity package.

### BACKGROUND OF THE INVENTION

Conventional integrated circuit plastic packaging methods involve encapsulating the integrated circuit using transfer molding techniques. In such a method, the molding compound is in contact with the surface of the integrated circuit. Since the various materials used in the chip and the package have different mechanical and physical properties, changes in the environment in which the packaged chip is used limit the package performance.

Chip reliability problems are often the result of the differences in properties of the packaging material. Many common reliability problems such as metal shear, passivation, silicon, and package cracking during printed wiring board attach are at least partially attributable to the difference in properties. As an example, the thermal performance of the package is limited by the thermal conductivity of the molding compound used to encapsulate the chip.

The cavity package concept allows manufacture of a package with various thermal connection options not available with conventional plastic packages. Cavity packages also provide a package with a cavity for mounting the integrated circuit chip with no contact between molding compound and the chip. With the thermal connection options available with the cavity package, more costly ceramic packaging can be avoided.

Prior art plastic cavity packages and processes have not provided a durable and reliable lid seal, which affects the reliability of the packaged integrated circuit chip.

One such prior art method is the comb mold approach with package seals at the leadframe interface. The disadvantages of this method are difficulty in manufacturing, poor moisture performance, difficult mold alignment and high tooling cost.

Another problem with prior art plastic cavity packaging efforts involves adhesion and surface preparation of the various parts which are to be bonded together. Adhesion between the adhesive and polymer and metal adherands and inadequate. Additionally, prior surface preparation methods were not compatible with process flow.

The applicants' earlier US-A-4 874 722, on which the preamble of claim 1 is based, discloses a method of producing a cavity package semiconductor device in which a plastics ring is moulded round a bar pad on which an integrated circuit chip is mounted, and top and bottom lids are then fastened to the ring using a thermosetting sealing compound.

"Glow Discharge Processes" by B. Chapman (John Wiley & Sons, New York, NY, USA, 1980), pages 253 & 255, describes the use of a plasma to clean the surfaces of materials, or to treat the surfaces of polymeric materials before other processing.

The invention provides a method of packaging an integrated circuit in a package having a plastics ring formed around the integrated circuit and at least one lid; comprising the steps of: preparing an adherand surface of the lid; preparing an adherand surface of the ring; and sealing the lid to the ring; characterised in that the said step of preparing the surface of the ring comprises exposing the ring with the integrated circuit inside it to a plasma.

In the drawings:

Fig. 1 is a cross-sectional view of a cavity package mounted to a printed wiring board.

Fig. 2 is a graph showing the cleaning effect of different plasma gases on adhesion (1 psi = 6.9 x 10³ Pa).

Fig. 3 is a graph showing the effect of cleaning time on adhesion (1 psi = 6.9 x 10³ Pa).

Fig. 4 is a cross-sectional view of the cavity package of Fig. 1 during a portion of the packaging process.

Fig. 5 is a block diagram of the process flow of the instant invention.

This application is related to U.S. Patent No. 4,874,722.

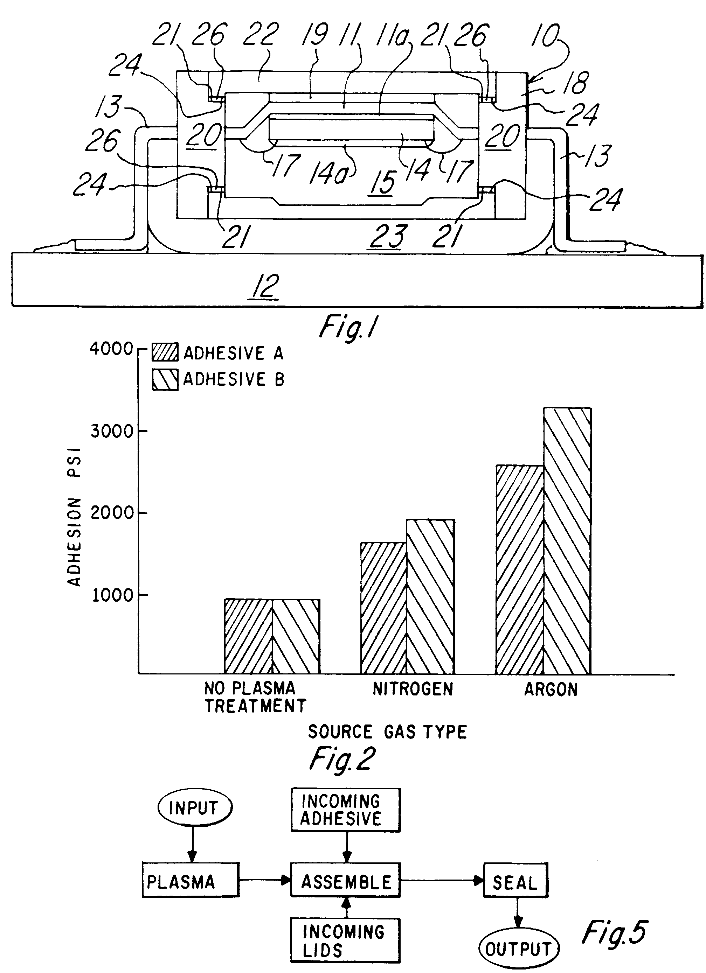

A plastic cavity package 10 of the present invention is illustrated in Fig. 1. The cavity package 10 is shown attached to printed wiring board 12. An integrated circuit chip 14 is attached to the die pad 11 of a lead frame 13 with an adhesive 11a. The chip 14 is positioned in cavity 15 within package 10. Wire bonds 17 attach the bond pads (not shown) of chip 14 to the lead frame 13. Portions of the lead frame 13 extend through cavity package 10 for electrically connecting the package 10 to the printed wiring board 12. A thermal adhesive 19 attaches the die pad 11 to lid 22. A silicone overcoat 14a may also be formed over chip 14 for further protection.

The cavity package 10 has a ring portion 18, preferably a polymer compound, which forms cavity 15 and is adapted to enclose integrated circuit chip 14. While in the preferred embodiment as shown in Fig. 1 the ring 18 is rectangular, it could be any suitable shape. The ring 18 is formed around lead frame 13 by a process as described in co-pending U.S. patent application serial No. 511,877, filed 04/20/90 US-A-5 106 784, reference No. TI-13619.1, also owned by the assignee hereof.

As seen in Fig. 1, ring 18 has lid-engaging shoulders 20, which extend into cavity 15. In the preferred embodiment, shoulders 20 extend around the entire inner side of ring 18. The shoulder 20 has lid-engaging surfaces 21 which also preferably extend aound the periphery of cavity 15. The surfaces 21 are adapted to sealingly engage upper lid 22 and lower lid 23.

Upper lids 22 and lower lids 23 are adapted to fit within the opening defined by ring 18 and engage surfaces 21 of shoulder 20 and contact surface 24 which extends around the periphery of lids 22. Contact surfaces 24 are adapted for sealing engagement with shoulders 20 when lids 22 are placed on the package 10.

The lids may be made of different material, depending upon the application of the package. They can be metal, such as aluminum,stainless steel, copper, or metal alloys. Plastic, either thermoset or thermoplastic may also be used. If necessary, high thermoconductivity materials, such as tungsten or tungsten alloys, silver, gold plating or cadmium plating could be used.

If the package of the instant invention is to be used to package EPROMS, it is necessary that the lid transmit UV light. Materials such as quartz, borosilicate glass, or sapphire may be used. Another possibility would be gold plated Kovar with bullseye quartz glass centers for passage of UV light.

It is also within the scope of the present invention that the package 10 may also have only one lid 22 or 23. As an example, if the package 10 is used to package an EPROM, it would be possible to use ring 18 and lid 23, with only an overcoat of some the in place of lid 22. Any other type of semiconductor chip could also be packaged in the same way.

The shape of the lid 22 may also differ from that shown if the package is required to have high power capability. Since heat dissipation is necessary in such application, the lid may have fins, or other protrusions extending from it.

In order to form a seal between surfaces 24 and lid-engaging surfaces 20, an adhesive 26 is placed between surfaces 24 and lid-engaging surfaces 20. In order to have a seal which will withstand stress and moisture, it is necessary to prepare surfaces 24 and 20 prior to assembly of the cavity package 10.

Surface preparation of the Ring 18 and Lid 22 is essential to achieve effective bonding of the ring 18 and lid 22 together in order to assure reliability of the finished product. Proper preparation of the adherands (ring 18 and lid 22) ensures that the adhesive will properly wet the surfaces to be bonded. If the adhesive does not wet the surfaces properly, the bond will be weaker and unreliable. The strongest bond results when the weakest point in the joint is in the adhesive layer itself, not in the interface between the adhesive and the adherand.

Preparation of the surface of lid 22 may require one or all of the folloowing steps: cleaning, roughening, stabilization, and activation.

If the package is to include a plastic lid, the preferred method of the present invention involves preparing the surfaces 20 and 24 with a plasma. The plasma is preferably isotropic in nature so that complex surface geometries can be prepared. Since materials used in the assembly process other than the lids 22 and the ring 18 may be exposed to the plasma, the plasma used should not be harmful to the non-adherand materials used in the assembly process.

The polymer surfaces are prepared ( which can include cleaning and modification) using a plasma surface treatment process. The adherands (ring 18 and lids 22) are placed in the plasma environment. The plasma is preferably generated using radio frequencies of 40 kHz or 13.56 MHz. Source gases are preferably argon or nitrogen. The ring 18 and lids 22 are supported in a plasma chamber either directly on the electrodes or on shelves between electrodes.

An example of a surface preparation process used with a plastic ring 18 and lid 22 assembly is as follows: applying RF frequency energy at 13.56 MHz and 150 Watts, with a gas flow reate of 90 CC/Min at a pressure in the plasma chamber of 240 microns. The process runs for 10 minutes at a temperature between 85-100°C. The gas is preferably argon.

The process described above is not harmful to non-adherand materials used in the assembly process, such as silicon nitride and silicone overcoats, gold bond wires, leadframe plating, chip metallization and bumps. The process is also easily inserted in-line with the remainder of the overall cavity packaging process flow, thus minimizing cost and process flow disruption.

The process of preparing the adherands of the instant invention effectively prepares the surfaces without the necessity of chemical or mechanical preparation. This process also changes the fracture modes in the package from adhesion failure to cohesive fracture mode, which is desirable as it gives maximum strength to the package.

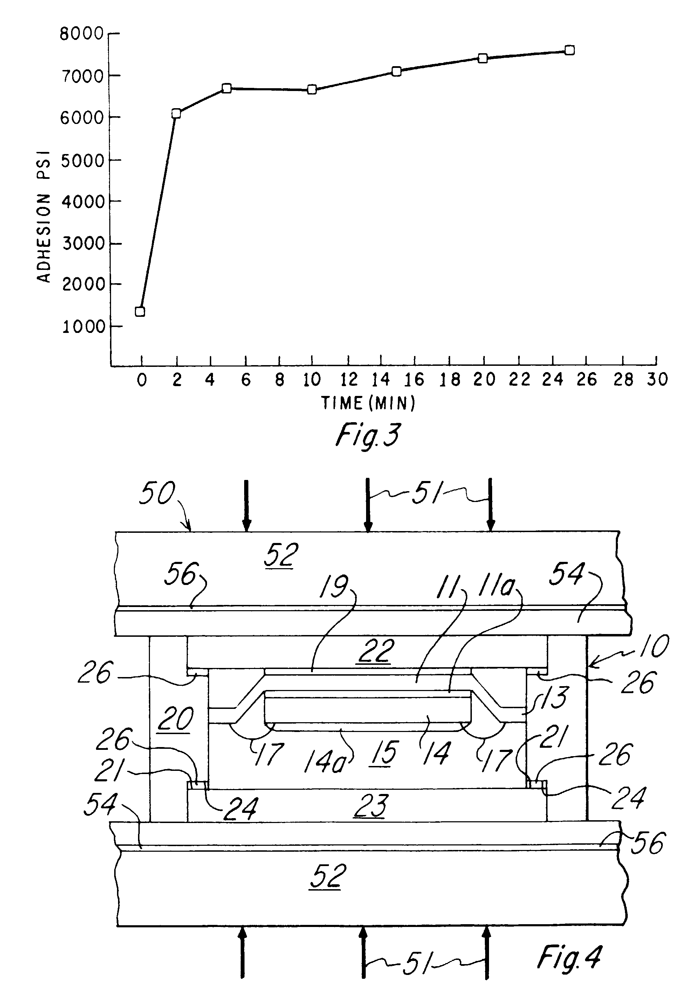

Figures 2 & 3 compare the adhesion with various types of plasma gases and varying preparation times. As shown in Fig. 2, the adhesion strength of bonds made after preparation with either an argon plasma or nitrogen plasma are substantially greater than bonds made when no plasma preparation has taken place.

Fig. 3 demonstrates the increase in adhesion strength as a function of plasma preparation time in a plasma generated with a frequency of 13.56 MHz.

If the lid 22 is made of metal, surface preparation using chemical methods may be used. Copper metals can be prepared using, either a black oxide coating, such as Ebonol "C", or an ammonium persulfate preparation process can be utilized. If the lid is Kovar, a nitric acid or chromium trioxide-hydrochloric acid mixture could be used to prepare the surface.

A glass lid 22 used on EPROM packages could be prepared using one of several methods. One method would be a solvent clean or vapor degrease using a light sandblast with a fine grit, followed by blowing the surface clean with filtered air. A second method would be a degrease as a first step, wash in a mixture of chromium trioxide (1 PBW) and distilled water (4 PBW) for 15-20 Min. at room temperature, followed by a wash with distilled water and drying at 82°C - 93°C (180-200 F)for 20-30 minutes. A third method would be an ultrasonic detergent bath followed by a rinse in distilled water and drying at room temperature.

For a ceramic lid, a recommended preparation process would be a vapor degrease, sanding with 200 sandpaper, and a vacuum or air spray clean. The glaze finish should be completely removed from the surface in contact with adhesive for maximum strength.

If the lid 22 is aluminum, the preferred method of preparation is Preparation of Aluminum Surfaces for Structural Adhesive Bonding (Phosphoric Acid Anodizing), designated as ASTM Designation D3933-80 (Annual Book of ASTM Standards, Part 22. This method is outlined below:
1. a degrease step, using 1,1,1 Trichloroethane for 10-15 min. @ 90°C+/-5°C.
2. Alkaline clean, using Oakite No. 164, for 10-15 min @ 60-72°C.
3. Rinse, using distilled water for > 5 min. @ >43°C.
4. Deoxidize (Forest Products Laboratories method), using Sodium Dichromate/Sulfuric for 10-15 min. @ 65-72°C.
5. Double Rinse using distilled water for >5 min @ 25°C.
6. Phosphoric Anodize, with Phosphoric Acid (75%)/Water, for 20-25 min. @ 15V+/- 1V.
7. Rinse with distilled water for 10-15 min @ 25°C.
8. Dry with heated air for 45 min. @ 70°C (max).
9. Inspect, using a Mercury Vapor Lamp with optical polarizing filter.
10. Adhesive Primer Application
   a. Spray primer, such as American Cyanamide BR-127 to 25 µm - 76 µm (0.001"- -0.003") thickness.
   b. Air dry > 30 min @ 25 °C.
   c. Oven dry for 30 min @ 112-121°C.

Other methods of preparing the surface of various metals can be found in Preparation of Metal Surfaces For Adhesive Bonding (ASTM Designation D2651-79 Reapproved 1984).

There is also disclosed a novel method for sealing a cavity package after cleaning and assembly steps have been completed, as illustrated in Fig. 4. In figure 4, a package 10 has been placed in a press 50. The press 50 applies pressure on both the top and bottom of the package 10, as shown by arrows 51. The press 50 may be either a single opening or multi opening press.

At both the top and bottom of package 10, a rigid metal sheet 52, of material such as stainless steel, is positioned between package 10 and press 50. A release film 54, preferably Pacothane(tm), is positioned between rigid sheets 52 and press pads 56. The press pads are preferably silicone rubber, such as COHRlastic (R) 3320.

The sealing process takes place with the pressure uniformly distributed over all the packages 10 within press 50. Special platen designs and a preprogrammed thermal profile applied throughout the sealing process result in reliable seals.

After the packages 10 and related sealing equipment described above are placed in press 50, a predetermined pressure at a predetermined temperature is applied to the packages 10 for a specific period of time. The pressure and temperature may follow a predetermined variable profile, or one or both may be constant.

An example would be: 344 kPa ± 34 kPa (50 +/- 5PSI) per package with the process temperature holding at 175°C for 60 minutes, with a cycle time of 75 minutes. Proper control of temperature during the sealing process is important, since the adhesive flow properties can depend on the heating rate, which will influence the bond line thickness.

During the sealing process, the seal between the press pads 56 and the package 10 is also very important, since internal pressure can develop within package 10. The pressure applied to the package 10 by press 50 should balance the internal pressure inside the package 10 to maximize bondline density and to prevent adhesive runoff from occurring. If runoff does occur, the bondline will not pack, and voids in the bondline may result, which causes a substandard bond. The use of silicone press pads 56 aids in preventing leakage. Also, since the pressure inside package 10 effectively packs the bondline, the silicone also acts as a stop for the flow of adhesive out onto the surface of the package 10, which would be a visual package defect.

After the temperature and pressure have been applied for the proper amount of time, a cooling cycle is begun, during which the pressure is maintained during controlled cooling. Some adhesives require that pressure be maintained until the adhesive sets or gels. In the preferred embodiment, the temperature at which the pressure is removed is approximately 93°C (200 °F).

An assembly flow for assembling an integrated circuit and a cavity package components could include the following steps:
1. Surface preparation of the lids, as described above for each type of material used.
2. Adhesive application to lid.
   a. adhesive preform applied to entire lid.
   b. adhesive preform applied in "window frame" fashion.
3. Plasma treatment of molded rings
4. assemble lids into molded rings.
5. Assemble heatspreaders into molded rings.
   a. silver filled material same as or similar to die attach adhesive.
   b. lid seal adhesive covering the entire heat spreader and the thermal attach is automatic.
6. lid seal step.

While the present invention has been described for use in a packaging process for a cavity package lid seal enhancement, the processes described herein could advantageously be used for cleaning any microelectronics package surface, such as degreasing prior to symolization. It could also be used with metal cavity packages, plastic packages, high power products, hybrid stacked memory, or multi-chip products.

## Claims

1. A method of packaging an integrated circuit (14) in a package (10) having a plastics ring (18) formed around the integrated circuit (14) and at least one lid (22,23); comprising the steps of: preparing an adherand surface (24) of the lid (22,23); preparing an adherand surface (21) of the ring (18); and sealing the lid to the ring; characterised in that the said step of preparing the surface (21) of the ring (18) comprises exposing the ring (18) with the integrated circuit (14) inside it to a plasma, to improve the adhesion of the lid (22, 23) to the ring (18).

2. A method according to claim 1, wherein the step of exposing comprises placing the ring (18) with the integrated circuit (14) inside it in a plasma chamber; and generating a plasma in the chamber.

3. A method according to claim 2, wherein the ring (18) with the integrated circuit (14) inside it is positioned between the electrodes in a plasma reactor.

4. A method according to claim 2 or claim 3, wherein the plasma is generated by introducing a reactant gas into the reactor; and exciting the reactant gas.

5. A method according to claim 5, wherein the reactant gas is excited by applying rf power to the plasma chamber.

6. A method according to any one of claims 1 to 5, wherein the step of exposing comprises reducing the pressure of the plasma below 1.0 x 10⁵ Pa (760 torr).

7. A method according to any one of claims 1 to 6, wherein the plasma is generated from nitrogen or argon.

8. A method according to any one of claims 1 to 7, wherein the lid (22,23) is of a plastics material and the step of preparing a surface of the lid comprises exposing the lid (22,23) to the plasma.

9. A method according to any one of claims 1 to 7, wherein the step of preparing the lid (22,23) comprises cleaning the lid.

10. A method according to claim 9, wherein the step of cleaning the lid (22,230) comprises placing the lid in an ultrasonic bath.

11. A method according to any one of claims 1 to 10, wherein the step of preparing the lid (22,23) comprises degreasing the lid.

12. A method according to claim 11, wherein the step of preparing the surface of the lid (22,23) comprises deoxidising the surface, anodising the surface, and applying an adhesive primer to the surface.

13. A method according to claim 9, wherein the step of preparing the lid (22,23) comprises cleaning the surface of the lid with an acid mixture.

14. A method according to claim 13, wherein the step of preparing the lid (22,23) comprises degreasing the lid, immersing the lid in a sulphuric acid bath, rinsing the lid in distilled water, and drying the lid.

15. A method according to any one of claims 1 to 14, which comprises attaching the integrated circuit chip (14) to a lead frame (13); interconnecting the chip (14) to the lead frame (13); and forming the ring (18) around the chip (14).

16. A method according to any one of claims 1 to 15, which comprises placing heatspreaders into the ring (18) before sealing the lid (22,23) to the ring (18).

17. A method according to any one of claims 1 to 16, wherein the step of sealing comprises placing an adhesive (26) on the lid (22,23) or the ring (18).

18. A method according to any one of claims 1 to 17, wherein the step of sealing comprises applying pressure (51) to the package (10) for a predetermined time.

19. A method according to claim 18, wherein the step of sealing comprises heating the package (10) to a predetermined temperature while maintaining the pressure (51).

20. A method according to claim 19, wherein the step of sealing comprises maintaining the pressure (51) while cooling the package (10).

21. A method according to claim 19 or claim 20, which comprises maintaining the temperature according to a predetermined profile.

22. A method according to any one of claims 18 to 21, which comprises maintaining the pressure (51) according to a predetermined profile.

23. A method according to any one of claims 18 to 22, wherein the step of applying pressure comprises placing the package (10) in a press (50).

24. A method according to claim 23, which comprises placing a pad (56) between the press (50) and the package (10) before applying pressure (51) to the package (10).

## Patentansprüche

1. Verfahren zum Einbauen einer integrierten Schaltung (14) in ein Gehäuse (10) mit einem Kunststoffring (18), der um die integrierte Schaltung (14) gebildet ist, und wenigstens einem Deckel (22, 23), enthalten die Schritte: Erzeugen einer Klebefläche (24) des Deckels (22, 23), Erzeugen einer Klebefläche (21) des Rings (18), dichtes Verbinden des Deckels mit dem Ring, dadurch gekennzeichnet, daß beim Erzeugen der Fläche (21) des Rings (18) der Ring (18) mit der in ihm befindlichen integrierten Schaltung (14) einem Plasma ausgesetzt wird, um die Haftung des Deckels (22, 23) am Ring (18) zu verbessern.

2. Verfahren nach Anspruch 1, bei welchem der Schritt des Aussetzens das Anbringen des Rings (18) mit der in ihm befindlichen integrierten Schaltung (14) in einer Plasmakammer umfaßt und in der Kammer ein Plasma erzeugt wird.

3. Verfahren nach Anspruch 2, bei welchem der Ring (18) mit der in ihm befindlichen integrierten Schaltung (14) zwischen den Elektroden in einem Plasmareaktor angebracht wird.

4. Verfahren nach Anspruch 2 oder Anspruch 3, bei welchem das Plasma durch Einführen eines Reaktionsgases in den Reaktor erzeugt wird und das Reaktionsgas angeregt wird.

5. Verfahren nach Anspruch 4, bei welchem das Reaktionsgas durch Anlegen von HF-Energie an die Plasmakammer angeregt wird.

6. Verfahren nach einem der Ansprüche 1 bis 5, bei welchem der Schritt des Aussetzens das Reduzieren des Plasmadrucks unter 1,0 x 10⁵ Pa (760 torr) umfaßt.

7. Verfahren nach einem der Ansprüche 1 bis 6, bei welchem das Plasma aus Stickstoff oder Argon erzeugt wird.

8. Verfahren nach einem der Ansprüche 1 bis 7, bei welchem der Deckel (22, 23) aus einem Kunststoffmaterial besteht und der Schritt des Erzeugens einer Fläche des Deckels das Aussetzen des Deckels (22, 23) dem Plasma umfaßt.

9. Verfahren nach einem der Ansprüche 1 bis 7, bei welchem der Schritt des Erzeugens des Deckels (22, 23) das Reinigen des Deckels umfaßt.

10. Verfahren nach Anspruch 9, bei welchem der Schritt des Reinigens des Deckels (22, 23) das Anbringen des Deckels in einem Ultraschallbad umfaßt.

11. Verfahren nach einem der Ansprüche 1 bis 10, bei welchem der Schritt des Erzeugens des Deckels (22, 23) das Entfetten des Deckels umfaßt.

12. Verfahren nach Anspruch 11, bei welchem der schritt des Erzeugens der Fläche des Deckels (22, 23) das Desoxidieren, das Anodisieren der Fläche und das Auftragen einer klebenden Grundierung auf die Fläche umfaßt.

13. Verfahren nach Anspruch 9, bei welchem der Schritt des Erzeugens des Deckels (22, 23) das Reinigen der Fläche des Deckels mit einer Säuremischung umfaßt.

14. Verfahren nach Anspruch 13, bei welchem der Schritt des Erzeugens des Deckels (22, 23) das Entfetten des Deckels, das Eintauchen des Deckels in ein Schwefelsäurebad, das Spülen des Deckels in destilliertem Wasser und das Trocknen des Deckels umfaßt.

15. Verfahren nach einem der Ansprüche 1 bis 14, das das Befestigen des integrierten Schaltungschips (14) an einem Leiterrahmen (13), das Verbinden des Chips (14) mit dem Leiterrahmen (13) und das Bilden des Rings (18) um den Chip (14) herum umfaßt.

16. Verfahren nach einem der Ansprüche 1 bis 15, das das Anbringen von Wärmeverteilern in dem Ring (18) vor dem dichten Verbinden des Deckels (22, 23) mit dem Ring (18) umfaßt.

17. Verfahren nach einem der Ansprüche 1 bis 16, bei welchem der Schritt des dichten Verbindens das Anbringen eines Klebstoffs (26) an dem Deckel (22, 23) oder an dem Ring (18) umfaßt.

18. Verfahren nach einem der Ansprüche 1 bis 17, bei welchem der Schritt des dichten Verbindens das Ausüben von Druck (51) auf das Gehäuse (10) für eine vorbestimmte Zeitdauer umfaßt.

19. Verfahren nach Anspruch 18, bei welchem der Schritt des dichten Verbindens das Erwärmen des Gehäuses (10) auf eine vorbestimmte Temperatur während der Aufrechterhaltung des Drucks (51) umfaßt.

20. Verfahren nach Anspruch 19, bei welchem der Schritt des dichten Verbindens das Aufrechterhalten des Drucks (51) während des Abkühlens des Gehäuses (10) umfaßt.

21. Verfahren nach Anspruch 19 oder Anspruch 20, das das Aufrechterhalten der Temperatur gemäß einem vorbestimmten Profil umfaßt.

22. Verfahren nach einem der Ansprüche 18 bis 21, das das Aufrechterhalten des Drucks (51) entsprechend einem vorbestimmten Profil umfaßt.

23. Verfahren nach einem der Ansprüche 18 bis 22, bei welchem der Schritt des Aufbringens von Druck das Anbringen des Gehäuses (10) in einer Presse (50) umfaßt.

24. Verfahren nach Anspruch 23, das das Anbringen eines Polsters (56) zwischen der Presse (50) und dem Gehäuse (10) vor dem Ausüben von Druck (51) auf das Gehäuse (10) umfaßt.

## Revendications

1. Procédé de conditionnement d'un circuit intégré (14) dans un conditionnement (10) ayant une bague plastique (18) formée autour du circuit intégré (14) et au moins un couvercle (22, 23) ; comprenent les étapes de:
préparer une surface adhésive (24) du couvercle (22, 23) ; préparer une surface adhésive (21) de la bague (18) ; et sceller le couvercle à le bague ;
caractérisé en ce que ladite étape de préparation de la surface (21) de la bague (18) comprend l'exposition de la bague (18) avec le circuit intégré (14) à l'intérieur de celle-ci à un plasma pour améliorer l'adhérence du couvercle (22, 23) à la bague (18).

2. Procédé selon la revendication 1, dans lequel l'étape d'exposition comprend le placement de la bague (18) avec le circuit intégré (14) à i'intérieur de celle-ci dans une chambre à plasma ; et la génération d'un plasma à l'intérieur de la chambre.

3. Procédé selon la revendication 2. dans lequel la bague (18) avec le circuit intégré (14) à l'intérieur de celle-ci est positionnée entre les électrodes dans un réacteur à plasma.

4. Procédé selon la revendication 2 ou 3, dans lequel le plasma est engendré par introduction d'un gaz réactant dans le réacteur et excitation du gaz réactant.

5. Procédé selon la revendication 4, dans lequel le gaz réactant est excité par application d'une énergie RF à la chambre de plasma.

6. Procédé selon l'une quelconque des revendications 1 à 5, dans lequel l'étape d'exposition comprend une réduction de la pression du plasma au-dessous de 1,0x10⁵ Pa (760 torr).

7. Procédé selon l'une quelconque des revendications 1 à 6, dans lequel le plasma est engendré à partir d'azote ou d'argon.

8. Procédé selon l'une quelconque des revendications 1 à 7, dans lequel le couvercle (22, 23) est fait d'une matière plastique et l'étape de préparer une surface du couvercle comprend l'exposition du couvercle (22, 23) au plasma.

9. Procédé selon l'une quelconque des revendications 1 à 7, dans lequel l'étape de préparation du couvercle (22, 23) comprend le nettoyage du couvercle.

10. Procédé selon la revendication 9, dans lequel l'étape de nettoyage du couvercle (22, 230) comprend le placement du couvercle dans un bain à ultra-sons.

11. Procédé selon l'une quelconque des revendications 1 à 10, dans lequel l'étape de préparation du couvercle (22, 23) comprend le dégraissage du couvercle.

12. Procédé selon la revendication 11, dans lequel l'étape de préparation de la surface du couvercle (22, 23) comprend la désoxydation de la surface, l'anodisation de la surface, et l'application d'une couche de fond adhésive à la surface.

13. Procédé selon la revendication 9, dans lequel l'étape de préparation du couvercle (22, 23) comprend le nettoyage de la surface du couvercle avec un mélange acide.

14. Procédé selon la revendication 13, dans lequel l'étape de préparation du couvercle (22, 23) comprend le dégraissage du couvercle, l'immersion du couvercle dans un bain d'acide sulfurique, le rinçage du couvercle dans de l'eau distillée et le séchage du couvercle.

15. Procédé selon l'une quelconque des revendications 1 à 14, qui comprend la fixation de la puce de circuit intégré (14) à une structure conductrice (13) ; l'interconnection la puce (14) à la structure conductrice (13) ; et la formation de la bague (18) autour de la puce (14).

16. Procédé selon l'une quelconque des revendications 1 à 15, qui comprend le placement de diffuseurs de chaleur dans la bague (18) avant le scellement du couvercle (22, 23) à la bague (18).

17. Procédé selon l'une quelconque des revendications 1 à 16, dans lequel l'étape de scellement comprend le placement d'un adhésif (26) sur le couvercle (22, 23) ou la bague (18).

18. Procédé selon l'une quelconque des revendications 1 à 17, dans lequel l'étape de scellement comprend l'application d'une pression (51) au conditionnement (10) pendant une durée prédéterminée.

19. Procédé selon la revendication 18, dans lequel l'étape de scellement comprend le chauffage du conditionnement (10) à une température prédéterminée pendant le maintien de la pression (51).

20. Procédé selon la revendication 19, dans lequel l'étape de scellement comprend le maintien de la pression (51) pendant le refroidissement du conditionnement (10).

21. Procédé selon la revendication 19 ou 20, qui comprend le maintien de la température selon un profil prédéterminé.

22. Procédé selon l'une quelconque des revendications 18 à 21, qui comprend le maintien de la pression (51) selon un profil prédéterminé.

23. Procédé selon l'une quelconque des revendications 18 à 22, dans lequel l'étape d'application de pression comprend le placement du conditionnement (10) dans une presse (50).

24. Procédé selon la revendication 23 qui comprend le placement d'un patin (56) entre la presse (50) et le conditionnemant (10) avant l'application de la pression (51) au conditionnement (10).
